# EUROPÄISCHE PATENTSCHRIFT

(11) **EP 2 789 959 B1**
(45) Veröffentlichungstag und Bekanntmachung des Hinweises auf die Patenterteilung: **26.12.2018**
(21) Anmeldenummer: 14450011.3
(22) Anmeldetag: 07.04.2014
(51) Int. Cl.: F27B 7/34, F27D 99/00

(54) **Verfahren zum Verbrennen von fossilen Brennstoffen und Ersatzbrennstoffen und Brenner zum Ausführen des Verfahrens**
Method for burning fossil fuels and substitute fuels and burner for carrying out the said method
Procédé de combustion de combustibles fossiles et de combustibles de substitution et brûleur destiné à exécuter le procédé

(30) Priorität: 11.04.2013 AT 2882013
(43) Veröffentlichungstag der Anmeldung: 15.10.2014
(73) Patentinhaber: A TEC Holding GmbH, 9585 Gödersdorf (AT)
(72) Erfinder: Maia, Joel, 9500 Villach (AT); Helmreich, Christian, 2102 Hagenbrunn (AT)
(74) Vertreter: Beer & Partner Patentanwälte KG

(56) Entgegenhaltungen:
- EP-A1- 0 887 589

## Beschreibung

Die Erfindung betrifft ein Verfahren und einen zum Ausführen des Verfahrens verwendbaren Brenner mit den Merkmalen der Oberbegriffe der unabhängigen Ansprüche.

Der durchschnittliche Energieeintrag der Feuerung (dem Brennbetrieb) in einem Zement- oder Kalkwerk zum Herstellen von Zement oder Kalk, sowie ähnlichen Steine-Erden-Produkten, die in einer Drehofenanlage kalziniert werden, ist mit 400 bis 2.500 kcal/kg (1.676 bis 10.475 kJ/kg) in der Regel sehr hoch.

Zurzeit werden in österreichischen und deutschen Zementwerken feste Ersatzbrennstoffe (Sekundärbrennstoffe) mit einer wärmeäquivalenten Substitutionsrate von bis zu 15 bis 50% verfeuert. D.h., in manchen Werken ist es möglich die Brennstoffwärmeleistung von ca. 15 bis 50% mit festen Ersatzbrennstoffen abzudecken und die restliche Energie mit klassischen Brennstoffen wie Öl, Gas oder Kohle einzubringen, um Kalkstein zu brennen und Zementklinker herzustellen.

In weiten Teilen von Europa ist der Einsatz von festen Ersatzbrennstoffen noch eher gering (bis zu 25% des benötigten Energieeintrages) aber im Steigen begriffen. In den USA, Afrika, Asien, Russland und im mittleren Osten ist diese Technik meist nicht im Einsatz, da es keine Altstoffsammelsysteme wie in Europa gibt.

Fester Ersatzbrennstoff ist in der Regel aufbereiteter, brennbarer Rückstand aus Produktionsbetrieben.

Der Ersatzbrennstoff (auch Fluff oder RDF genannt) wird in einer großteils zweidimensionalen (flächigen) Fraktion verwendet, die überwiegend aus einer Mischung von Kunststoffen, Papier, Pappe, Textilien, Holz und Teppichresten besteht. Diese Fraktion mit einem Mindestheizwert von ca. 3.500 kcal/kg (= 14.665 kJ/kg) und einer Kantenlänge bis zu 50 mm wird dem Brenner mit Förderluft pneumatisch zugeführt.

Stand der Technik ist, dass alle Hersteller von Brennern für Drehrohröfen Ersatzbrennstoffe zentral, d.h. in der Mitte des Brenners, innerhalb der festen fossilen Brennstoffe (Kohle, Petkoks) durch ein, zwei oder mehrere kreisförmig angeordnete Führungsrohre pneumatisch und unter reduzierenden Bedingungen (Sauerstoffmangel) in die bestehende Hauptflamme eindüsen.

Die notwendige Verbrennungsluft wird zum Hauptteil über die vom Klinkerkühler reokkupierte, heiße Sekundärluft (88 bis 94% der stöchiometrischen Verbrennungsluft), sowie über die kalte Primärluft durch den Brenner (6 bis 25%) der stöchiometrischen Verbrennungsluft bezogen.

Primärluft wird mittels Hochdruckgebläse/Ventilatoren gefördert, die für den entsprechenden hohen Impuls für die Brennstoffmischung und das Abbrandverhalten der Brennstoffmischung (fossiler Brennstoff und Ersatzbrennstoffe) ausgelegt ist. Die Form der Flamme (Durchmesser und Länge der Flamme) wird über Luftkanäle am Brenner eingestellt.

Das Zufeuern von festen, stückigen Ersatzbrennstoffen (EBS) zu üblichen, fossilen Brennstoffen (vorrangig Kohle, Gas und Öl) ist in geringen Substitutionsraten problemlos möglich. Steigt der Ersatzbrennstoffanteil auf über ca. 30% der Wärmeleistung, so entstehen deutliche produktqualitative und anlagenspezifische Probleme.

Fein gemahlener Kohlestaub reagiert an der Flammenoberfläche stark mit Sauerstoff, im Flammenkern hingegen kann der Ersatzbrennstoff unter Sauerstoffmangel vorerst nicht zünden. Erst wenn ein Großteil der flüchtigen Anteile der Kohle abgebrannt ist und wieder genügend Sauerstoff vorhanden ist, kann der Ersatzbrennstoff zünden und der Abbrand stattfinden.

Dadurch entsteht die Problematik der Flammenverschleppung, Verschieben des Ofen-Thermoprofils, unverbrannte Brennstoffpartikel im Produkt/gebrannter Kalk und Zementklinker etc., wodurch der Herstellungsprozess massiv gestört wird. Der Impuls der Primärluft, der zum Formen der Flamme notwendig ist, verringert sich mit zunehmendem Abstand von der Brennermündung gegen Null. Darum kann die Flamme bei der bisher bekannten Brennerausführung bei Verwendung hoher Ersatzbrennstoffanteile nur mehr schlecht bis gar nicht eingestellt werden.

Erfahrungswerte zeigen, dass konstante, über Jahresmittelwert gerechnete Brennstoff-Substitutionsraten über 60% durch feste, stückige Ersatzbrennstoffe bisher kaum möglich sind.

Die üblichen produktionstechnischen Einschränkungen und Nachteile bestehen in:
- Erhöhtem Feinkalkgehalt im Zementklinker (niedrigere Flammentemperatur)
- Unverbrannte Rückstände im Brenngut (niedrigere Klinkerqualität)
- Verschlechterung der Produkt-Eigenschaften
- Doppelflammenbildung (zwei schlecht kontrollierbare Flammenausbildungen)
- Verschiebung und Verlängerung der Sinterzone Richtung Ofeneinlauf
- Veränderung des gesamten Thermoprofils des Ofens
- Erhöhung der Ofeneinlauftemperatur (Flammenverschleppung)
- Erhöhung der Schadstoffkreisläufe im Ofen und damit die Gefahr der starken Ansatzbildung im Ofen und deren vorgeschalteten Aggregate

Die EP 0 887 589 A1 beschreibt eine Vorrichtung und ein Verfahren für das Verbrennen von Brennstoffen, insbesondere in einem Drehrohrofen für das Brennen von Zementklinker. Dabei wird u.a. durch zwei um die Achse einer Brennerlanze angeordnete Öffnungen Schweröl oder Gas in den Brennraum eingedüst und durch einen symmetrisch um diese Achse angeordneten Ringspalt zusätzlich fester (staubförmiger) Brennstoff eingeblasen. Die Zufuhr der benötigten Verbrennungsluft erfolgt durch einen zwischen diesen beiden Brennstoffzuführungen gelegenen und einen außerhalb der Brennstoffzuführung für festen Brennstoff gelegenen Lochkreis. Als fester Brennstoff kommt neben Kohle- oder Koksstaub auch Ersatzbrennstoff in Form von Kunstharz-, Haushalts- oder Holzabfällen zum Einsatz.

Aus der JP 2003-130549 A ist ein Drehrohrofen für das Brennen von Zementklinker bekannt. In die Frontplatte des Ofens ist ein Hauptbrennerrohr eingebaut, durch das Kohlestaub eingeblasen wird. Oberhalb des Hauptbrennerrohres ist eine Zusatzbrennerlanze eingebaut, durch die Kohlestaub, aber auch brennbarer Abfall mit Abmessungen zwischen 15 - 20 mm als Ersatzbrennstoff, zugeführt wird.

Der Erfindung liegt die Aufgabe zugrunde, ein Verfahren zur maximalen Substitution der Feuerungswärmeleistung mit festen Ersatzbrennstoffen und einem Brenner für insbesondere Drehrohröfen für Produktionsprozesse der Steine-Erden-Industrie zur Verfügung zu stellen.

Gelöst wird diese Aufgabe mit einem Verfahren, das die Merkmale des unabhängigen, auf ein Verfahren gerichteten, Anspruchs aufweist.

Insoweit der Brenner betroffen ist, wird die der Erfindung zugrunde liegende Aufgabe mit einem Brenner gelöst, der die Merkmale des unabhängigen, auf einen Brenner gerichteten Anspruchs aufweist.

Das Verfahren der Erfindung erlaubt eine Maximierung der Substitution fossiler Brennstoffe durch feste Ersatzbrennstoffe in einem Brenner, insbesondere einem Brenner für einen Drehrohrofen. Der Brenner der Erfindung eignet sich, fossile Brennstoffe (Kohle, Öl, Gas) weitgehend bis vollständig durch feste, stückige Ersatzbrennstoffe zu ersetzen. Dadurch können fossile Brennstoffe eingespart, CO₂-Emissionen verkleinert und Brennstoffkosten stark verringert werden.

Ein bevorzugtes Merkmal der Konstruktion des Brenners liegt darin, dass der Ersatzbrennstoff nicht, wie bei bekannten Brennerausführungen, im Zentrum des Brenners und somit innerhalb des Kohlekanales, sondern außerhalb dessen durch einen oder mehrere ringförmig angeordnete Brennstoffkanäle zugeführt wird. Weiters wird der wenigstens eine Brennstoffkanal zur verbesserten Brennstoffaufteilung in der Hauptflamme herangezogen. Somit kann der zur Verbrennung notwendige Sauerstoff der heißen Verbrennungsluft (Sekundärluft) in der Flamme sofort mit aufbereitem, stückigem Ersatzbrennstoff reagieren. Ein rasches Zünden der Flamme und die dadurch mögliche einfache Flammenkontrolle sind Vorteile der Erfindung.

Bevorzugt wird Ersatzbrennstoff aufbereitet verwendet. Die Kantenlänge des stückigen Ersatzbrennstoffs beträgt bei der zweidimensionalen (flächigen) Fraktion bevorzugt bis zu 15 mm. Für dreidimensionale Fraktionen beträgt die Kantenlänge bevorzugt bis zu 7 mm. Der Feuchtegehalt des Ersatzbrennstoffs sollte unter 20% rel.F liegen, um die Zündfähigkeit und das Abbrandverhalten kontrollieren zu können.

Der Ersatzbrennstoff wird zu dem Brenner bevorzugt pneumatisch transportiert, dessen pneumatische Eindüsegeschwindigkeit in dem Ringkanal einstellbar ausgeführt ist und kann mittels (gesondert) zugeführter Ersatzbrennstoff-Zuluft am Brenner genau geregelt werden.

Das Verfahren der Erfindung erlaubt eine bis zu 100% Substitution von fossilen Brennstoffen durch Ersatzbrennstoffe.

Durch das Verfahren und den Brenner gemäß der Erfindung gelangt kein unverbrannter Ersatzbrennstoff (z.B.: Kunststoff, Pappe, Papier, Textilie) in das erzeugte Produkt. Dies, weil kein Ersatzbrennstoff aus der Flamme fällt und teilweise unverbrannt an der Oberfläche des Produktes eingeschlossen wird.

Damit wird der Anteil an reduzierend hergestelltem Produkt (z.B. brauner Klinker) ebenso vermieden wie Produktverunreinigungen. Diese Vorteile der Erfindung erhöhen die Produktqualität.

Ein verbesserter Ofenbetrieb aufgrund verstellbarer Form, Länge und Temperatur der Flamme kann mit dem Verfahren der Erfindung eingestellt werden. Weiters werden Ansatzbildungen, Ringbekämpfung und Manteltemperaturveränderung verhindert. Dies erhöht die Lebensdauer der Ofenausmauerung. Durch den vermehrten Einsatz von Ersatzbrennstoffen mit biogenen Anteilen können CO₂ Einsparungen erreicht werden.

Ein konzentrisch aufgebauter Brenner für einen Drehrohrofen gemäß der Erfindung besitzt bevorzugt einen oder mehrere ringförmig ausgebildete Ersatzbrennstoff-Brennstoffkanäle zum bevorzugt pneumatischen Transport von festen Ersatzbrennstoffen in Verbindung mit einem ringförmigen Kanal zum Transport eines fossilen Primärbrennstoffs.

Bei dem erfindungsgemäßen Brenner kann der Ersatzbrennstoff-Kanal als Ringspaltdüse konzentrisch ohne Einschnürung außerhalb des Kohlekanals (fossiler Festbrennstoff-Brennstoffkanal) angeordnet sein. Die lichte Kanalweite (Breite des Ringspaltes) beträgt beispielsweise das ein- bis dreifache der maximalen Kantenlänge des aufbereiteten Ersatzbrennstoffs. Dies erlaubt einen verstopfungsunempfindlichen Betrieb.

Zwischen dem Ersatzbrennstoff-Kanal und dem Kohlekanal ist gemäß einer Ausführungsform der Erfindungein Tangentialluftkanal angeordnet, der Luft zum Formen der Flamme zuführt. Dieser konzentrisch angeordnete Luftkanal mit radial angeordneten Drallkörpern kann mit Vorteil zum Einstellen der Form der Flamme (Durchmesser der Flamme) verwendet werden.

Innerhalb des Kohlekanals ist ein Drallluftkanal für Dispersionsluft angeordnet. Dadurch kann eine innere Rezirkulationszone der Flamme gebildet werden, die sich flammenstabilisierend auswirkt.

Der Ersatzbrennstoff-Kanal weist beispielsweise eine Kanalaufhängung auf, die mittels durchgängig angeordneten Lineals (Leiste) über die gesamte Brennstoff-Kanallänge eine Kanaldistanzierung vornimmt. Diese Kanaldistanzierung ist beispielsweise mit dem Innenrohr und dem Außenrohr des Kanals verschraubt ausgeführt. Die Distanzierung ist insbesondere oben am Ersatzbrennstoff-Kanal angeordnet, da sich Ersatzbrennstoff durch die Gravitation eher im unteren Bereich des Ersatzbrennstoff-Kanals verteilt anordnet. Der Ersatzbrennstoff-Kanal kann zusätzlich durch Ersatzbrennstoff-Kanalflansche in Position gehalten werden. Diese Anordnung ist verstopfungsfrei für feste Ersatzbrennstoffe, d.h. ohne Störkörper, ausgebildet.

Weitere Einzelheiten und Merkmale der Erfindung ergeben sich aus der nachstehenden Beschreibung unter Bezugnahme auf die angeschlossenen Zeichnungen. Es zeigt:
- Fig. 1: einen Schnitt durch einen erfindungsgemäß ausgebildeten Brenner und
- Fig. 2: einen erfindungsgemäßen Brenner in Seitenansicht.

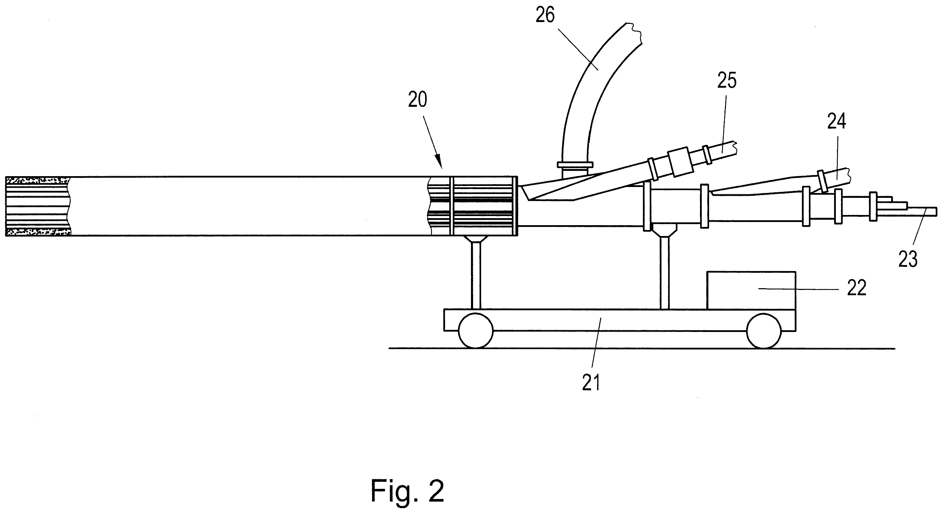

Ein in Fig. 2 in Seitenansicht gezeigter Brenner ist als Drehrohrofenbrenner 20 ausgebildet und auf einem Brennerwagen 21 aufgebaut, auf dem auch, um ein Kippen des Drehofenbrenners 20 zu vermeiden, ein Gegengewicht 22 angeordnet ist.

In dem Brenner 20 befindet sich eine Öllanze 23, ein Kohleanschluss 24 und ein Anschluss 25 zum Zuführen von Ersatzbrennstoff. Des Weiteren ist an dem Brenner - im Beispiel von oben kommend - ein Schlauch 26 angeschlossen, über den Primärluft zugeführt wird.

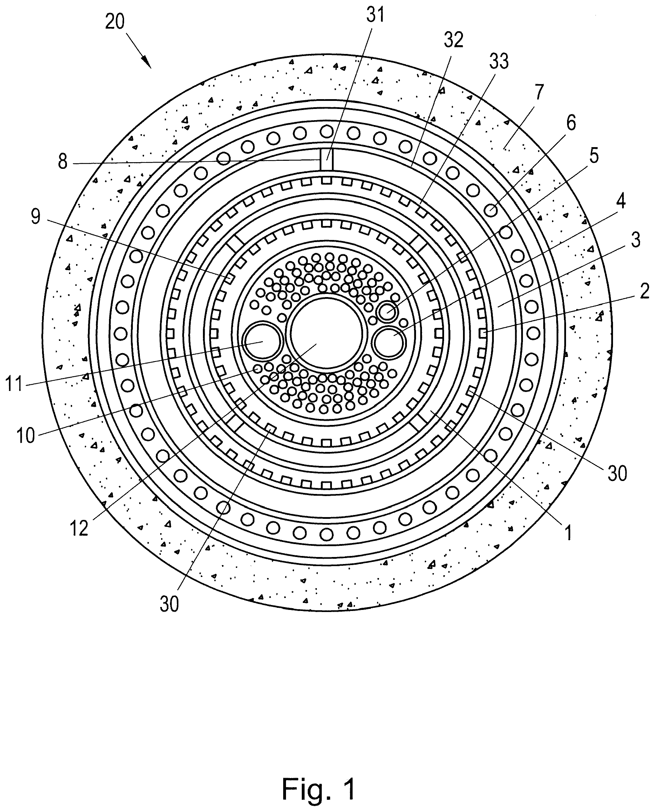

Der erfindungsgemäße Brenner 20 ist, wie Fig. 1 zeigt, aus mehreren konzentrisch zueinander angeordneten Bauteilen aufgebaut. Wesentliches Merkmal der in den Figuren 1 und 2 gezeigten Ausführungsform ist ein ringförmig ausgebildeter Kanal 3, durch den Ersatzbrennstoff pneumatisch zugeführt werden kann. Dabei ist der Kanal 3 zum Zuführen von Ersatzbrennstoff konzentrisch und ohne Einschnürung außerhalb eines Kanals 1, über den Kohle zugeführt wird, angeordnet.

Um Verstopfungen zu vermeiden, beträgt die lichte Weite des Kanals 3 (= Breite des Ringspaltes) beispielsweise das zwei- bis dreifache der maximalen Kantenlänge von aufbereitetem Ersatzbrennstoff, wobei die Kantenlänge bei zweidimensionalem Ersatzbrennstoff beispielsweise bis zu 15 mm und bei dreidimensionalem Ersatzbrennstoff beispielsweise bis zu 7 mm betragen kann.

Zwischen dem Kanal 3 zum Zuführen von Ersatzbrennstoff einerseits und dem Kanal 1 zum Zuführen von Kohle anderseits ist bei der in den Figuren 1 und 2 gezeigten Ausführungsform ein Kanal 2 zum Zuführen von Tangentialluft angeordnet. Durch diese Tangentialluft wird die Flamme geformt. Hierzu sind in dem Kanal 2 radial angeordnete Drallkörper 30 vorgesehen, sodass das Einstellen der Flammenform (Flammendurchmesser) besonders vorteilhaft möglich ist.

Innerhalb des Kanals 1 für das Zuführen von Kohle ist ein weiterer Kanal 9 angeordnet, durch den Dispersionsluft zugeführt wird. Auch im Kanal 9 sind Drallkörper 30 vorgesehen, sodass die aus dem Kanal 9 austretende Dispersionsluft eine innere Rezirkulationszone in der Flamme bildet und so eine Stabilisierung der Flamme erreicht wird.

Innerhalb des Kanals 9 für Dispersionsluft sind Leitungen 10 für das Zuführen von Kühlluft vorgesehen. Zusätzlich sind dort ein Lösemitteltragrohr 11, ein Öllanzentragrohr 12, ein Zündbrennertragrohr 4 sowie ein Flammüberwachungstragrohr 5 vorgesehen.

Außerhalb des Kanals 3 für das Zuführen von Ersatzbrennstoff sind Kanäle 6 für das Zuführen von externer Luft angeordnet. Schließlich ist der Brenner 20 außen durch eine Ausmauerung 7 umgeben.

Der Kanal 3 für das Zuführen von Ersatzbrennstoff wird im gezeigten Ausführungsbeispiel mit Vorteil durch eine Aufhängung 8 gehalten. Die Aufhängung 8 umfasst eine durchgängig angeordnete Leiste 31, die sich über die gesamte Länge des Kanals 3 erstreckt und ein Ausrichten des Kanals 3 übernimmt. Die Leiste 31 der Aufhängung 8 des Kanals 3 für das Zuführen von Ersatzbrennstoff kann mit dem Innenrohr 32 und dem Außenrohr 33 (also den Rohren, die den Kanal 3 begrenzen) durch Verschraubung verbunden sein. Von Vorteil ist die Aufhängung 8 für den Kanal 3 zum Zuführen von Ersatzbrennstoff im oberen Bereich des Kanals 3 angeordnet.

Zusätzlich kann der Kanal 3 für das Zuführen von Ersatzbrennstoff durch Flansche am Kanal 3 in seiner Position gehalten werden.

Wie erwähnt, ist der Kanal 6 für das Zuführen externer Luft außerhalb des Kanals 3 für das Zuführen von Ersatzbrennstoff angeordnet. Durch den Kanal 6 wird Primärluft zugeführt, die einen im Wesentlichen axialen Mischimpuls des Brenners bewirkt. Durch die über den Kanal 6 zugeführte externe Luft (Primärluft) wird die axiale Länge der Flamme auf den jeweils gewünschten Wert eingestellt und das Einmischen von Sauerstoff in die Flamme bewirkt. Dabei ist es bevorzugt, dass kreisförmig angeordnete Düsen Sekundärluft (Temperatur etwa 800°C) vom Kühler selbsttätig in die Flamme ansaugen und einmischen (Injektorwirkung).

## Patentansprüche

1. Verfahren zum Verbrennen von fossilen Brennstoffen und Ersatzbrennstoffen, in einem Brenner, insbesondere in einem Brenner für den Betrieb eines Drehrohrofens, wobei der Ersatzbrennstoff der Flamme in einem Bereich zugeführt wird, der außerhalb des Bereiches, in dem fossiler Brennstoff der Flamme zugeführt wird, liegt, **dadurch gekennzeichnet, dass** Ersatzbrennstoff in Form einer zweidimensionalen (flächigen) Fraktion mit einer Kantenlänge von bis zu 15 mm verwendet wird oder in Form einer dreidimensionalen Fraktion mit einer Kantenlänge von bis zu 7 mm verwendet wird.

2. Verfahren nach Anspruch 1, **dadurch gekennzeichnet, dass** der Ersatzbrennstoff in einem dem Bereich, in den fossiler Brennstoff zugeführt wird, ringförmig umgebenden Bereich zugeführt wird.

3. Verfahren nach Anspruch 1 oder 2, **dadurch gekennzeichnet, dass** Ersatzbrennstoff mit einem Feuchtegehalt von 20% relative Feuchte verwendet wird.

4. Verfahren nach einem der Ansprüche 1 bis 3, **dadurch gekennzeichnet, dass** Ersatzbrennstoff pneumatisch gefördert wird, wenn er dem Brenner zugeführt wird.

5. Brenner (20), bevorzugt Brenner für einen Drehrohrofen, zum Durchführen des Verfahrens nach einem der Ansprüche 1 bis 4, mit einem Kanal (1) zum Zuführen von fossilem Brennstoff, dem eine Öllanze (23) und ein Kohleanschluss (24) zugeordnet sind, einem Anschluss (25) für das Zuführen von Ersatzbrennstoff und einem Anschluss (26) für das Zuführen von Primärluft, **dadurch gekennzeichnet, dass** ein Kanal (3) für das Zuführen von Ersatzbrennstoff ringförmig um den Kanal (1) für das Zuführen von fossilem Brennstoff angeordnet ist.

6. Brenner nach Anspruch 5, **dadurch gekennzeichnet, dass** der Kanal (3) für das Zuführen von Ersatzbrennstoff durch zwei zueinander konzentrisch angeordnete Rohre (32, 33) begrenzt ist, die durch eine Aufhängung (8) für das innere Rohr (33) der beiden Rohre (32, 33) miteinander verbunden sind.

7. Brenner nach Anspruch 6, **dadurch gekennzeichnet, dass** die Aufhängung (8) eine Leiste umfasst, die sich über die gesamte Länge des Brenners (20) erstreckt.

8. Vorrichtung nach einem der Ansprüche 4 bis 6, **dadurch gekennzeichnet, dass** die lichte Weite des Kanals (3) zum Zuführen von Ersatzbrennstoff das zwei- bis dreifache der maximalen Kantenlänge des zugeführten Ersatzbrennstoffes beträgt.

## Claims

1. Method for burning fossil fuels and substitute fuels in a burner, in particular in a burner for operating a rotary kiln, wherein the substitute fuel is supplied to the flame in a region outside the region in which fossil fuel is supplied to the flame, **characterized in that** substitute fuel is used in the form of a two-dimensional (flat) fraction with an edge length of up to 15 mm or in the form of a three-dimensional fraction with an edge length of up to 7 mm.

2. Method according to claim 1, **characterized in that** the substitute fuel is supplied in a region annularly surrounding the region into which fossil fuel is supplied.

3. Method according to claim 1 or 2, **characterized in that** substitute fuel with a moisture content of 20% relative humidity is used.

4. Method according to one of claims 1 to 3, **characterized in that** substitute fuel is pneumatically conveyed when it is supplied to the burner.

5. Burner (20), preferably burner for a rotary kiln, for carrying out the method according to one of claims 1 to 4, having a channel (1) for supplying fossil fuel, to which an oil lance (23) and a coal connection (24) are assigned, a connection (25) for supplying substitute fuel and a connection (26) for supplying primary air, **characterized in that** a channel (3) for supplying substitute fuel is arranged annularly around the channel (1) for supplying fossil fuel.

6. Burner according to claim 5, **characterized in that** the channel (3) for supplying substitute fuel is delimited by two tubes (32, 33) arranged concentrically with one another and connected to one another by a suspension (8) for the inner tube (33) of the two tubes (32, 33).

7. Burner according to claim 6, **characterized in that** the suspension (8) comprises a strip extending over the entire length of the burner (20).

8. Device according to one of claims 4 to 6, **characterized in that** the clear width of the channel (3) for supplying substitute fuel is two to three times the maximum edge length of the supplied substitute fuel.

## Revendications

1. Procédé de combustion de combustibles fossiles et de combustibles de substitution dans un brûleur, en particulier dans un brûleur faisant fonctionner un four tubulaire rotatif, dans lequel le combustible de substitution est amené à la flamme dans une zone située en dehors de celle où du combustible fossile est amené à la flamme, **caractérisé en ce que** le combustible de substitution est utilisé sous la forme d'une fraction à deux dimensions (plane) ayant une longueur de bords de jusqu'à 15 mm ou sous la forme d'une fraction à trois dimensions ayant une longueur d'arête de jusqu'à 7 mm.

2. Procédé selon la revendication 1, **caractérisé en ce que** le combustible de substitution est amené dans une zone qui entoure en formant un anneau la zone dans laquelle le combustible fossile est amené.

3. Procédé selon la revendication 1 ou 2, **caractérisé en ce que** le combustible de substitution est utilisé avec un taux d'humidité de 20 % d'humidité relative.

4. Procédé selon l'une des revendications 1 à 3, **caractérisé en ce que** le combustible de substitution est acheminé par des moyens pneumatiques quand il est amené au brûleur.

5. Brûleur (20), de préférence brûleur pour un four tubulaire rotatif, pour la mise en oeuvre du procédé selon l'une des revendications 1 à 4, avec un canal (1) pour amener du combustible fossile auquel sont associés un injecteur de fuel (23) et un raccord de charbon (24), avec un raccord (25) pour amener du combustible de substitution et un raccord (26) pour amener de l'air primaire, **caractérisé en ce qu'**un canal (3) pour amener du combustible de substitution est disposé en formant un anneau autour du canal (1) pour amener le combustible fossile.

6. Brûleur selon la revendication 5, **caractérisé en ce que** le canal (3) pour amener le combustible de substitution est délimité par deux tuyaux concentriques (32, 33) qui sont reliés l'un à l'autre par une suspension (8) pour le tuyau intérieur (33) des deux tuyaux (32, 33).

7. Brûleur selon la revendication 6, **caractérisé en ce que** la suspension (8) comprend un bandeau qui s'étend sur toute la longueur du brûleur (20).

8. Dispositif selon l'une des revendications 4 à 6, **caractérisé en ce que** la largeur libre du canal (3) pour amener le combustible de substitution représente deux à trois fois la longueur d'arête maximale du combustible de substitution amené.
